Europäisches Patentamt

European Patent Office

Office européen des brevets

(19)

(11) EP 0 987 100 A2

## (12) EUROPEAN PATENT APPLICATION

(43) Date of publication:
22.03.2000 Bulletin 2000/12

(51) Int Cl.7: **B32B 15/08**, B44C 1/17, C23C 14/20

(21) Application number: 99402238.2

(22) Date of filing: 13.09.1999

(84) Designated Contracting States:
**AT BE CH CY DE DK ES FI FR GB GR IE IT LI LU MC NL PT SE**
Designated Extension States:
**AL LT LV MK RO SI**

(30) Priority: **14.09.1998 JP 25951198**

(71) Applicants:
• **Daicel Chemical Industries, Ltd.**
**Sakai-shi, Osaka-fu (JP)**
• **Unyck Co., Ltd.**
**Tokyo-to (JP)**

(72) Inventors:
• **Ishikawa, Masahiro**
**Matsudo-shi, Chiba-ken (JP)**
• **Nakamura, Masaya**
**Tokyo-to (JP)**

(74) Representative: **Portal, Gérard et al**
**Cabinet Beau de Loménie**
**158, rue de l'Université**
**75340 Paris Cédex 07 (FR)**

### (54) A degradable laminated body and a method for the preparation thereof

(57) Disclosed are a degradable laminated body which comprises a biodegradable resin layer and a metallic thin layer, which is high in strength, excellent in degradability, high in a property for shielding from the sunlight, temperature, and moisture, not apt to charge static electricity, being readily printed, and a method for the preparation thereof.

## Figure 1

EP 0 987 100 A2

**Description**

FIELD OF THE INVENTION

The present invention relates to a degradable body which comprises (A) a biodegradable resin layer composed of a biodegradable polyester resin composition containing an aliphatic polyester resin and a polylactone resin, and (B) a metallic thin layer which is laminated with at least one surface of the biodegradable resin layer. Furthermore, the present invention relates to a method for the preparation thereof.

BACKGROUND OF THE INVENTION

Hitherto, plastics such as polyolefines which are characterized by stability and durability, have been used in a variety of fields in addition to wrapping materials, construction materials, and parts for cars, and those have been consumed in a large amount. As a method for dumping after uses thereof, although there are enumerated burning and berrying underground, in resins which are difficult in degradation such as polyethylenes, polypropylenes, and polyvinyl chlorides, there is a problem that an incinerator is injured because of the high-calorie energy generated in burning thereof, or acidic gases such as hydrogen chloride, and chlorine gas which are also harmful for human, animals, and plants. Therefore, the use of a biodegradable resin has been investigated.

Although the biodegradable resin shows nearly identical physical properties to general purpose plastics in uses, after uses and dumping thereof, it is quickly decomposed by microorganisms such as bacteria and fungi or natural conditions such as temperature, humidity, and light, etc. under natural circumstances such as in active sludge, in soil, in water, and in a compost, and a certain kind of plastics finally change to carbon dioxide and water.

Heretofore, there has been known a biodegradable resin such as a starch-EVOH(polyvinyl alcohol)-based resin, an EVOH-aliphatic polyester-based resin, and an aliphatic polyester-polyolefine-based resin which are a blend-based resin composition, and those have been put into practice after molded into a variety of shapes.

Of those, an aliphatic polyester-based resin obtained by a chemical synthesis has been known as a resin which is drawn in attention, and which can be readily employed in a variety of fields owing to a relatively well-balanced moldability, costs, mechanical properties, and water resistance. The aliphatic polyester resin is typified by a polyester resin obtained by a polycondensation of an $\alpha,\omega$-bifunctional aliphatic diol with an $\alpha,\omega$-bifunctional aliphatic carboxylic acid.

In general, since it has a low melting point, it cannot be employed in place of conventional polyolefines.

However, it has been known that a certain kind of polyester resin has a low melting point of not less than 100°C, and it has thermoplasticity, whereby, an investigation for synthesis has been made. The polyester resin includes a polyester resin prepared from succinic acid and 1,4-butanediol, a polyester resin prepared from succinic acid and ethyleneglycol, a polyester resin prepared from oxalic acid and neopentylglycol, a polyester resin prepared from oxalic acid and 1,4-butanediol, and a polyester resin prepared from oxalic acid and ethyleneglycol. Of those, polyester resins prepared from oxalic acid are poor in a thermal stability, and those cannot be highly-polymerized.

On the other hand, it is known that the succinic acid-based aliphatic polyester resin has a relatively excellent thermal stability, and a modification for synthesis has been investigated.

However, even in the succinic acid-based aliphatic polyester-based resin, in the case that it is prepared by polycondensation using a usual apparatus, it is difficult to highly-polymerize, and there cannot be readily obtained a resin having a practical and mechanical strength. Therefore, it has been highly-polymerized by forming a urethane bond at terminal hydroxyl groups in the molecule thereof using a polyisocyanate.

As the aliphatic polyisocyanate compounds to be employed in the present invention, hexamethylene diisocyanate, etc. is employed owing to a more excellent biodegradability in an aliphatic-based one than an aromatic-based one.

As described hereinabove, in the present invention, an aliphatic polyester resin having a low molecular weight is highly-polymerized, and mechanical properties are improved, whereby, it can be applied to processing such as injection molding, blow molding, fiber-preparation, and film-preparation, etc.

However, even in the aliphatic polyester resin, in the case that crystallinity is high, or the urethane bond is introduced into a resin molecule as described hereinabove, there is a fact that biodegradability by microorganisms usually lowers.

The fact is also apparent from a result that biodegradation proceeds at a noncrystalline portion of the resin, a crystalline portion is difficult to be decomposed and apt to be remained, and even though there is employed a polycaprolactone polyol having an excellent biodegradability, in a caprolactone-based polyurethane prepared by hexamethylene diisocyanate which is an aliphatic polyisocyanate, biodegradation is not almost shown when it is tested in an active sludge for a biodegradation examination which is regulated according to JIS K6950.

Since such the tendency is shown even in a resin containing a urethane bond of a relatively low amount, even a polyester having an inherent biodegradability often causes a decline of biodegradability because of the presence of a small amount of urethane bonds of several % by weight which are inevitably produced through highly-polymerizing the polyester resin. In fact, in a polyester resin having a number average molecular weight of 40,000-50,000 highly-polymerized by connecting terminal hydroxy groups in 4-5 pieces of succinic acid-based polyester having a number average molecular weight of 10,000 or so using a polyisocyanate, when the polyester resin is tested in an active sludge for a biodegradation examination which is regulated according to JIS K6950, there is obtained an evaluation result of no-biodegradation.

Further, JP-A-08011206 Official Gazette proposes an improved downward-dice in order to prevent a draw down phenomenon in molding of a polyester-based biodegradable resin, and JP-A-08150658 official Gazette describes a method for the preparation of a starch-EVOH-polycaprolactone-based resin such as a specified temperature in molding and molding conditions.

JP-A-08188706 Official Gazette discloses a biodegradable plastic bag characterized by molding a composition in which there is formulated 0.3-0.8 part by weight of a lubricant based on 100 parts by weight of a composition of 80-100% by weight of a polycaprolactone with 20-0% by weight of a biodegradable linear chain polyester-based resin composition produced by a microorganism.

However, the above-described bag made from the composition of the polycaprolactone with the biodegradable linear chain polyester-based resin produced by a microorganism includes a problem in a mechanical strength, and it is difficult to mass-produce a film and, a bag obtained does not have a sufficiently quick biodegradation speed.

On the other hand, as a method for laminating a film or a sheet with a metal, there have been known a variety of methods for laminating by coextruding a film and a metallic foil or metallization of aluminum, etc. on the surface of a film (Encyclopedia of Practical Plastic Molding, pages 232-238 and 548-562, published by Sangyo-Chosakai, Ltd., 1997).

For example, as the laminating methods, there has been known a method for 3-layers-lamination by coextruding an aluminum foil together with a low density polyethylene film and a polyethylene terephthalate film.

Further, as a method for forming a metal-vaporized layer, there have been known a method for directly vaporizing aluminum over the surface of a film, and a method in which an under coating agent is coated over the surface of a film, and then, aluminum is vapor-deposited over the surface of the under coating layer formed.

Particularly, the former method has been known as a so-called vacuum-metallization method in which aluminum is vaporized under a vacuum atmosphere and deposited over the surface of a film to be deposited.

Still further, JP-A-09131830 Official Gazette discloses a method for the preparation of a laminated body by a decalcomania method of a metal-vaporized layer onto the surface of a plasticized polyvinyl chloride containing a plasticizer.

However, the above-described laminated bodies are not decomposed by microorganisms such as bacteria and fungi or natural conditions such as temperature, humidity, and light, etc. under natural circumstances.

In view of this background, and as a result of extensive investigation, the inventors of this invention have now found that there can be prepared a degradable laminated body from a biodegradable resin layer and a metallic thin layer.


<u>SUMMARY OF THE INVENTION</u>

It is an object of the present invention to provide a degradable laminated body composed of a resin layer and a metal layer, which is high in strength, excellent in degradability, high in a property for shielding the sunlight, temperature, and moisture, and not electrostatically charged and, further, easy in printing.

A first aspect of the present invention relates to a degradable laminated body which comprises (A) a biodegradable resin layer consisting essentially of a biodegradable polyester resin composition containing 100 parts by weight of an aliphatic polyester resin and 1-200 parts by weight of a polylactone resin, and (B) a metallic thin layer which is laminated with at least one surface of said biodegradable resin layer.

A second aspect of the present invention relates to a method for the preparation of a degradable laminated body by laminating a biodegradable resin layer with a metallic foil.

Advantageous invention embodiments are set forth in the claims, which are incorporated herein in their entirety by reference.


BRIEF DESCRIPTION OF DRAWINGS

Figure 1 shows a cross-sectional drawing of a degradable laminated body having a biodegradable resin layer and a metallic thin layer in the present invention.

Figure 2 shows a cross-sectional drawing of a degradable laminated body having a biodegradable resin layer, an adhesive layer, and a metallic thin layer in the present invention.

Figure 3 shows a cross-sectional drawing of a degradable laminated body having an adhesive layer which is formed between a biodegradable layer and a metallic thin layer by a decalcomania method in the present invention.

Figure 4 shows a cross-sectional drawing of a degradable laminated body having a biodegradable resin layer, a metallic thin layer, and a surface coating layer formed on the surface of the metallic thin layer.

Figure 5 shows a cross-sectional drawing of a degradable laminated body having a biodegradable resin layer, a metallic thin layer, a pressure-sensitive adhesive layer formed under the biodegradable resin layer, and a releasing paper formed under the pressure-sensitive adhesive layer.

DETAILED DESCRIPTION OF THE INVENTION

According to the first aspect of the present invention, there is provided a degradable laminated body which comprises (A) a biodegradable resin layer consisting essentially of a biodegradable polyester resin composition containing 100 parts by weight of an aliphatic polyester resin and 1-200 parts by weight of a polylactone resin, and (B) a metallic thin layer which is laminated with at least one surface of said biodegradable resin layer.

According to the second aspect of the present invention, there is provided a method for the preparation of a degradable laminated body by laminating a biodegradable resin layer with a metallic foil.

The present invention will be described hereinafter in more detail.

(A) Biodegradable resin layer

The biodegradable resin layer (A) is composed of a film, a sheet, and nonwoven fabrics or webs, etc., and the thickness of the layer is 10 microns to 10 mm, and it may be a single layer or a laminated layer.

1. Biodegradable polyester resin composition

The biodegradable polyester resin composition is a mixture in which a polycaprolactone is mixed in a mixing ratio of 1-200 parts by weight, preferably 5-50 parts by weight, and more preferably 20-40 parts by weight with 100 parts by weight of an aliphatic polyester resin.

(1) Polylactone

The polylactone to be employed in the present invention can be prepared by subjecting a lactone monomer such as $\varepsilon$-caprolactone, trimethyl-$\varepsilon$-caprolactone, $\delta$-valerolactone, and $\beta$-propiolactone to ring-opening polymerization of a compound having active hydrogens such as ethyleneglycol, diethyleneglycol, and a minor amount of water present in the lactone monomer, etc., as an initiating agent under the presence of an appropriate catalyst.

Functionality in the above-described initiating agent is not particularly limited, and bifunctional and trifunctional compounds are employed. The number average molecular weight can be adjusted by controlling the amount of the minor water and/or the above described initiating agents. In the case that the amount of water and/or the initiating agent is larger, the molecular weight of the resin is lower. On the other hand, in the case that the amount of water and/ or the initiating agent is small, the molecular weight of the resin is higher.

The polylactone to be employed in the present invention has a number average molecular weight value of from 1,000 to 200,000, preferably from 5,000 to 100,000, and more preferably from 10,000 to 100,000.

In the case that there is employed the polylactone having a low number average molecular weight value, although the moldability is preferably improved owing to a low melting viscosity in the resin composition, there unpreferably lowers thermal resistance and mechanical strength in the resulting aliphatic polyester resin composition, resulting in that the use amount is limited and biodegradability is not improved so much.

On the other hand, although there can be also employed the polylactone having a number average molecular weight value exceeding 200,000, it is difficult to industrially mass-produce the polyactone having a number average molecular weight. In the case that a polylactone having a high molecular weight is employed, mixing ratio can be increased, whereby, heat resistance, mechanical properties, and biodegradability can be all highly-well balanced, and it is more preferred.

In order to obtain the polylactone having a number average molecular weight value ranging from 10,000 to 100,000 to be preferably employed in the present invention, a very minor amount (specifically, 0.025 % or less) of water present in the monomer or minor amount of ethyleneglycol is preferably employed as the initiating agent in the ring-opening polymerization.

In the ring-opening polymerization, a catalyst is preferably used, and as the catalyst used for the ring-opening polymerization, including, for example, an organic tin compound, and a stannous halide and an organic titanium compound.

The catalyst is used in an amount of from 0.1 to 5,000 ppm by weight, based on the lactone monomers. The polymerization temperature is preferably from 100 to 230 °C, preferably at an inert gas atmosphere in order to obtain a high quality polylactone.

Preferred examples of the polylactone to be employed in the present invention include PCL H-series (having a number average molecular weight of from 10,000 to 100,000) of a polycaprolactone commercially supplied by Daicel Chemical Industries, Ltd.

Of the above described PCL H-series, particularly, there can be more preferably used the polycaprolactone having the number average molecular weight of from 50,000 to 70,000 from viewpoint of mechanical properties thereof.

It is noted that the preferred polylactone having the above described range of the number average molecular weight corresponds to the resin having a relative viscosity value of from 1.15 to 2.80, which can be produced by polymerizing with the minor amount of water in a lactone monomer and/or ethyleneglycol, etc. as an initiating agent.

There is disclosed a process for the preparation of the polylactone having the above-described range of the number average molecular weight in the US Patent Nos. 4,745,171, 4,357,462, and 4,289,873, etc.

In the polylactone to be employed in the present invention, the relative viscosity value is measured by a capillary viscometer (Ubbelohde's viscometer) according to Japanese Industrial Standard K 6726, using toluene solution containing 1% of the polylactone.

The measurement of the relative viscosity value is carried out while maintaining a temperature of 25.00°C ± 0.05°C.

The lactone monomer may be employed solely or in combination.

Furthermore, there can be copolymerized a copolymerizable monomer such as glycolide or lactide together with the lactone monomers, for example, within 20% by weight.

In the biodegradable polyester resin composition of the present invention, the polylactone is mixed in an amount ranging from 1 to 200 parts by weight, preferably from 5 to 50 parts by weight, and more preferably from 20 to 40 parts by weight based on 100 parts by weight of the aliphatic polyester resin.

In the case that the polylactone is mixed below 1 part by weight, biodegradability is not improved in the aliphatic polyester resin composition so much, unpreferably resulting in that mixing of the polylactone becomes meaningless.

On the contrary, in the case that the polylactone is mixed exceeding 200 parts by weight, thermal resistance unpreferably lowers in a film or sheet, etc. molded from the resin composition.

In order to prepare the aliphatic polyester resin composition of the present invention, the polylactone and the aliphatic polyester resin described hereinafter are mixed in a dry state with a mixer such as a Henshel mixer or a ribbon blender, followed by being extruded in a melting state with a single or twin screw extruder, a Banbury mixer, a kneader, and a mixing roll, etc. which are conventional mixers to be employed in a melting state.

(2) Aliphatic polyester resin

The aliphatic polyester resin may be an aliphatic polyester resin not containing urethane bonds or containing urethane bonds described below.

(2-1) Aliphatic polyester resin not containing urethane bonds

One example of an aliphatic polyester resin is a polyester of a low molecular weight dicarboxylic acid with a low molecular weight diol, and there is preferred a polyester of a linear or branched aliphatic diol having a carbon number of 1-10 with a linear or branched aliphatic dicarboxylic acid having a carbon number of 1-10.

There is preferably employed a polyester in which the content of the diol is 20% by weight to 70% by weight, and the content of the dicarboxylic acid is 80% by weight to 30% by weight.

Further, as the aliphatic polyester resin, there is preferred one having a melting point of not less than 100°C, and having thermoplasticity. Specifically, there can be enumerated a polyester resin prepared from succinic acid and/or adipic acid and 1,4-butanediol, a polyester resin prepared from succinic acid and/or adipic acid and ethyleneglycol, a polyester resin prepared from oxalic acid and neopentylglycol, a polyester resin prepared from oxalic acid and 1,4-butanediol, and a polyester resin prepared from oxalic acid and ethyleneglycol. Of those, polyester resins prepared from oxalic acid are poor in a thermal stability, and those cannot be highly-polymerized.

The polyester prepared by a combination of 1,4-butanediol and succinic acid or succinic anhydride has a melting point of 110 to 130°C, and a polyester prepared by a combination of ethylene glycol and succinic acid or succinic anhydride has a melting point of approximately 125°C.

As other polyols to be employed for preparing the aliphatic polyester, there are specifically exemplified 1,6-hexanediol, 1,8-octanediol, and 1,10-decanediol, ethyleneglycol, and neopentylglycol.

As other examples of the aliphatic polyester resin, there can be enumerated a biodegradable plyester resin such as a synthetic polylactic acid, an aliphatic polyester which is a terpolymer described in JP-A-09235360 and JP-A-09233956 Official Gazettes, a copolymer of lactic acid with a hydroxycarboxylic acid described in JP-A-07177826 Official Gazette, a polyamide ester resin prepared from ε-caprolactone and ε-caprolactam, and a polyamino acid resin, etc. In the aliphatic polyester resin, a number average molecular weight is 20,000-200,000, preferably not less than 40,000 based on a standard Polystyrene by GPC. As the aliphatic polyester resin prepared from a diol/dicarboxylic acid, there can be exemplified "Bionolle" (manufactured by Showa Kobunshi, Co. Ltd.) not containing urethane bonds.

As a commercially supplied product of a polylactic acid, there can be enumerated ECOPLA (Kirguil Co.) and Lacty (manufactured by Shimadzu Seisakusho, Ltd.).

(2-2) Aliphatic polyester resin containing urethane bonds

Thus-prepared aliphatic polyester, particularly, an aliphatic polyester having a low molecular weight is optionally allowed to react with an aliphatic polyisocyanate compound such as hexamethylene diisocyanate in an amount ranging from 0.1 to 5 parts by weight based on 100 parts by weight of the aliphatic polyester.

As the aliphatic polyisocyanate compound other than hexamethylene diisocyanate, there can be employed methyl ester of lysinediisocyanate $[OCN-(CH_2)_4-CH(-NCO)(-COOCH_3)]$ and trimethylhexamethylene diisocyanate, etc. Of those, there are more preferably employed hexamethylene diisocyanate.

Although the use amount of the aliphatic diisocyanate compounds depends upon the molecular weight of the aliphatic polyester resin, it ranges from 0.1 to 5 parts by weight, preferably from 0.5 to 3 parts by weight, and more preferably from 1 to 2 parts by weight based on 100 parts by weight of the polyester resin. Furthermore, although it is theoretically optimum for the equivalent ratio of hydroxyl groups to isocyanate groups to be 1, the use of one of the components in an excess amount at an equivalent ratio of approximately 0.5 does not cause problems in practical uses.

The aliphatic diisocyanate compounds are preferably added to the aliphatic polyester resin in a melting state in the absence of solvents under conditions in which agitation can be readily carried out. Furthermore, the aliphatic diisocyanate compounds can be added to the aliphatic polyester resin in a solid state, and the mixture can be melted and mixed in a mixer such as an extruder.

It is already reported in the literature "Story of biodegradable plastics" published by the Association of Japanese Standard (pages 59-66, 1991) that the aliphatic polyester resin containing urethane bonds has biodegradability.

The reaction for increasing molecular weight is carried out at a temperature range from 170 to 230°C, preferably from 180 to 220°C under high vacuum such as 1 Torr or less from the viewpoint of the reaction rate and prevention of decomposition. In the case that the temperature is below 170°C, the reaction unpreferably proceeds slowly, and a resulting product does not exhibit practical properties and, contrarily, in the case that the temperature exceeds 230°C, decomposition of the product is unpreferably caused.

Thus-prepared aliphatic polyester resin containing urethane bonds has a number average molecular weight (Mn) of at least 20,000, preferably at least 40,000.

An aliphatic polyester resin having a low molecular weight, for example, a number average molecular weight (Mn) of less than 20,000, has the following disadvantages. A resin having excellent mechanical properties cannot be obtained even though using 0.1 to 5 parts by weight of a polyisocyanate.

Furthermore, gelation is often caused during a reaction in a melting state even in the use of a small amount of the polyisocyanate compound.

The aliphatic polyester resin to be employed in the present invention contains at least one urethane bonds per a number average molecular weight of approximately 5,000.

Thus-prepared aliphatic polyester resin has a general formula (1) or (2) described below;

$$H-(OR^1O-COR^2CO)_{m}1-O-R^1-[OCONHR^3NHCOOR^1O-(COR^2-CO-OR^1O)_{m2}]_n-$$

$$-CONHR^3NHCOOR^1O(COR^2COOR^1O)_{m3}-H \qquad (1)$$

in the formula (1), m1, m2, and m3 by which there is satisfied a number average molecular weight ranging from 10,000 to 200,000 are a polymerization degree which may be identical or different from each other, n is 0 or an integer of not less than 1, $R^1$ and $R^2$ are an alkylene group, a group having an alicyclic ring, and a cycloalkylene group having a carbon number ranging from 2 to 10 which may be branched or substituted by an alkyl group having a carbon number ranging from 1 to 3, and $R^3$ is a residual group derived from a polyisocyanate compound, and

$$H(OR^1O-COR^2CO)_{m}-O-R^1-OH \qquad (2)$$

in the formula (2), m by which there is satisfied a number average molecular weight ranging from 25,000 to 70,000 is

a polymerization degree, $R^1$ and $R^2$ are an alkylene group, a group having an alicyclic ring, and a cycloalkylene group having a carbon number ranging from 2 to 10 which may be branched or substituted by an alkyl group having a carbon number ranging from 1 to 3.

In the formulae (1) and (2), $-(OR^1O\text{-}COR^2CO)_m\text{-}$, $-(OR^1O\text{-}COR^2CO)_m1\text{-}$, $-(OR^1O\text{-}COR^2CO)_m2\text{-}$, and $-(OR^1O\text{-}COR^2CO)_m3\text{-}$ represent a polyester chain derived from polycondensation of a bifunctional aliphatic alcohol with a bifunctional aliphatic carboxylic acid, and $R^1$ and $R^2$ are a residual group derived from the bifunctional alcohol and bifunctional carboxylic acid, respectively.

Although thus-prepared aliphatic polyester resin containing urethane bonds has a relatively passable biodegradability compared to other many synthetic plastics, it is not sufficient.

The aliphatic polyester resin composition in the present invention can be prepared by mixing the aliphatic polyester resin with a polylactone resin, and the composition exhibits a further excellent biodegradability without a loss of other properties.

(3) Additives for resins

In the biodegradable polyester resin composition, there may be optionally mixed the additives for resins such as a biodegradable plasticizer, a thermal stabilizer, a lubricant, an anti-blocking agent, a nucleating agent, a photo-decomposition accelerator, a biodegradability accelerator, an antioxidant, a self-oxidation agent, an ultraviolet ray stabilizer, an antistatic agent, an electricity conducting agent, a flame retardant, a crosslinking agent, an anti-deodorant, a coloring agent, inorganic fillers such as calcium carbonate, talc, or silica which are an inorganic delustering agent, coloring agents such as pigments, dyes or carbon black, plasticizers such as a polycaprolactone polyol having a low molecular weight, etc.

Particularly, the addition of the photodecomposition accelerator and the self-oxidation agent is preferred in view of giving a brittleness to resins at a desired period after dumping.

Further, there may be mixed other biodegradable thermoplastic resins such as an ethylenic copolymer or other polyolefines, a hydrogenated styrene-butadiene rubber, a polyurethane, a polyamide, a resin prepared from a polyvinyl alcohol, a copolymer of 3-hydroxybutylate with 3-hydroxypivalate, and cellulose-based plastics, starch-based plastics, cellulose-based esters, and a polyester resin produced by microorganisms, etc., within a limit which does not adversely affect. Particularly, the addition of the photodegradation accelerator and self-oxidation agent is preferred in view of giving a brittleness to the film or sheet after a lapse of an appropriate period of time.

(3-1) Plasticizer

As the plasticizer to be employed in the present invention, there can be enumerated an aliphatic dibasic acid, a phthalate, a hydroxy multivalent carboxylate, a polyester-based plasticizer, a fatty acid ester, an epoxide-based plasticizer, and a mixture thereof.

Specifically, there are enumerated a phthalate such as di-2-ethylhexylphthalate (DOP), dibutyl phthalate (DBP), and di-2-isodecyl phthalate (DIDP), the hydroxy multivalent carboxylate such as di-2-ethylhexyladipate (DOA), diisodecyl adipate (DIDA), an azelaic acid ester such as azelaic-di-2-ethylhexyl (DOZ), the hydroxy multivalent carboxylate such as tri-2-ethylhexyl acetylsilicate and tributyl acetylsilicate, and a polypropyleneglycol adipate, etc., which are a polyester-based plasticizer. Those may be also employed in combination of two or more kinds. Preferably, azelaic-di-2-ethylhexyl (DOZ) is employed.

The addition amount of the plasticizers ranges in 3-30 parts by weight, more preferably 5-15 parts by weight based on 100 parts by weight of total amount of the polylactone and the aliphatic polyester resin. In the case of less than 3 parts by weight, extension at break and impact strength lower and, in the case of exceeding 30 parts by weight, strength at break and impact strength unpreferably lower.

(3-2) Thermal stabilizer

In the present invention, an aliphatic carboxylic acid salt is employed as a thermal stabilizer. As the aliphatic carboxylic acid, an aliphatic hydroxycarboxylic acid is particularly preferred. As the aliphatic hydroxycarboxylic acid, lactic acid and hydroxy lactic acid, etc. are preferred which exists in nature.

As salts, there can be enumerated sodium, calcium, aluminum, barium, magnesium, manganese, iron, zinc, lead, silver, and copper, etc. Those may be employed solely or in combination of two or more kinds.

The addition amount of the thermal stabilizer ranges in preferably 0.5-10 parts by weight, more preferably 0.5-5 parts by weight based on 100 parts by weight of total amount of the polylactone and the aliphatic polyester resin. By the use of the thermal stabilizer within the above-described range, there is shown an effect that impact strength (Izod impact strength) is improved, and a dispersion becomes small in extension at break, strength at break, and impact strength.

(3-3) Accelerator for photo-decomposition

As the accelerators for photo-decomposition, for example, there are exemplified benzoins, benzoin alkyl ethers, benzophenones and derivatives thereof such as benzophenone, and 4,4'-bis(dimethylamino)benzophenone; acetophenones and derivatives thereof such as acetophenone and $\alpha,\alpha$-diethoxyacetophenone; quinones; thioxanthones; a photo-exiting agent such as phthalocyanine, an anatase-type titanium oxide, an ethylene-carbon monoxide copolymer, and a sensitivity accelerator such as a metallic salt of an aromatic ketone, etc. The accelerator for photo-decomposition may be employed solely or in combination.

(3-4) Accelerator for biodegradation

As the accelerators for biodegradation, there are exemplified, for example, an organic acid such as an oxo acid (for example, an oxo acid having a carbon number of 2-6 or so such as glycolic acid, lactic acid, citric acid, tartaric acid, and malic acid), a saturated dicarboxylic acid (for example, a lower saturated dicarboxylic acid having a carbon number of 2-6 or so such as oxalic acid, malonic acid, succinic acid, succinic anhydride, and glutaric acid); a lower alkyl ester of the organic acids with an alcohol having a carbon number of 1-4 or so. A preferred accelerator for biodegradation includes citric acid, tartaric acid, and malic acid which are an organic acid having a carbon number of 2-6 or so, and an activated carbon made from coconut shells.

Further, as the accelerators for biodegradation, there are also included a hydrolysis enzyme such as biodegradable enzyme, for example, lipase, cellulase, and esterase, etc. The biodegradable enzyme can be employed by suspending or dispersing in a solvent. It is to be noted that the above-mentioned accelerators for photodegradation can be employed together with the accelerators for biodegradation. The accelerators for biodegradation are employed solely or in combination.

(3-5) Lubricants

As the lubricants to be employed in the present invention, there can be employed ones which can be usually employed as an internal lubricant and/or an external lubricant. For example, there are enumerated fatty acid esters, hydrocarbon resins, paraffins, higher fatty acids, oxyfatty acids, fatty acid amides, alkylenebis fatty acid amides, aliphatic ketones, fatty acid esters of a lower alcohol, fatty acid esters of a polyvalent alcohol, fatty acid esters of a polyglycol, aliphatic alcohols, polyvalent alcohols, polyglycols, polyglyceroles, metal soaps, modified silicones, and a mixture thereof. Preferably, fatty acid esters and hydrocarbon resins, etc. are enumerated.

More specifically, as the amide of a fatty acid, there are enumerated monoamides of a saturated fatty acid such as an amide of lauric acid, an amide of palmitic acid, an amide of a palmitic acid having a high purity, an amide of stearic acid, a refined amide of stearic acid, an amide of a stearic acid having a high purity, an amide of behenic acid, an amide of behenic acid having a high purity, an amide of hydroxystearic acid, and an amide of oleic acid; bisamides of a saturated fatty acid such as bisamide of methylenebis stearic acid, bisamide of ethylenebis capric acid, bisamide of ethylenebis lauric acid, bisamide of ethylenebis stearic acid, bisamide of ethylenebis isostearic acid, bisamide of ethylenebis hydroxystearic acid, bisamide of ethylenebis behenic acid, bisamide of hexamethylenebis stearic acid, bisamide of hexamethylenebis behenic acid, bisamide of hexamethylenebis hydroxystearic acid, bisamide of N, N'-distearyladipic acid, and bisamide of N,N'-distearylsebasic acid; monoamides of an unsaturated fatty acid such as monoamide of oleic acid, monoamide of a refined oleic acid, and monoamide of licinoleic acid; bisamides of an unsaturated fatty acid such as bisamide of ethylenebis oleic acide, bisamide of hexamethylenebis oleic acid, bisamide of N,N'-dioleiladipic acid, bisamide of N,N'-dioleilsebasic acid; substituted amides such as amide of N-stearylstearic acid, amide of N-oleiloleic acid, amide of N-stearyloleic acid, amide of N-oleilstearic acid, amide of N-stearyleruic acid, and amide of N-oleilpalmitic acid; amide of methylol stearic acid; methylol amides such as amide of methylol behenic acid; aromatic bisamides such as bisamide of N,N-distearyl isophthalic acid and bisamide of metaxylilene bistearylic acid.

These are a solid lubricant at ordinary temperatures.

In the case of selecting the lubricant, it is required that there is selected a lubricant having a melting point lower than those depending upon a melting point of a variety of aliphatic polyester resins. For example, there is selected an amide of a fatty acid having a melting point of not more than 160°C in consideration of a melting point of the synthetic aliphatic polyester resins.

There are preferred amide of ethylenebis stearic acid, amide of stearic acid, amide of oleic acid, and amide of erucic acid which are high in safeness, and registered in FDA (USA Food and Drug Administration) from a viewpoint of preventing environmental pollution.

Formulation amount of the lubricants ranges in 0.05-5 parts by weight, and preferably 0.1-3 parts by weight based on 100 parts by weight of total amount of the polylactone and the aliphatic polyester resins. Particularly, the formulation amount in the amides of a fatty acid preferably ranges in 0.2-5 parts by weight, and more preferably 0.3-1.5 parts by weight based on 100 parts by weight of total amount of the polylactone and the aliphatic polyester resin.

In the case that the amount of the lubricant is less than the above-described range, an effect for preventing blocking becomes slightly lower through an internal portion of a tubular film, or between a film and nip rolls or guide rolls and, on the other hand, in the case of exceeding the above-described range, a slipping property in the film becomes excessively high, resulting in that there becomes shown a tendency that a decline of printing applicability and an adhesive property, etc., in addition to a problem of a telescopic phenomenon in roll winding. As a commercially supplied product, there can be employed Rikestar-EW-100 (manufactured by Riken vitamin, Co.) and Hoechst Wax OP (manufactured by Hoechst, AG), etc.

In the liquid-state lubricants as a wetting agent, there is employed a lubricant having a melting point of not more than 70°C, and preferably, a liquid-state one at ordinary temperatures. For example, there are enumerated liquid paraffins, paraffin waxes, stearyl alcohol, stearic acid, and stearates such as butyl stearate, esters of stearic acid such as a monoglyceride of stearic acid, pentaerythritol tetrastearate, and stearyl stearate, etc.

It is to be noted that the liquid paraffins, which are most preferred in the above-described liquid-state lubricant, are very safe because an acute oral toxicity (rat) LD50 is 5 g/kg, and it is approved as an additive for foods in Food Hygiene Law, it is a very favorable material from a viewpoint of preventing environmental pollution in the case of having been dumped after the use of a film or a sheet.

In the case that the solid-state lubricant is employed, although it can be practically employed when a resin composition containing the resin has a higher melting point than a melting point in the solid lubricants, if the liquid-state lubricant is selected, melting is not required, and the liquid paraffin which is a liquid at room temperatures is a most preferred lubricant in view of unnecessity of melting.

Purpose of employing the liquid-state lubricant depends upon that the polylactone and the aliphatic polyester resin, which are polymer components, are usually supplied in the form of pellets or beads, and there is homogeneously mixed the finely-powdered silica having an exceedingly small bulk density described hereinafter and, further, the surface of the pellets or beads must be wetted by all means.

Addition amount of the liquid-state lubricant to be employed as described hereinabove is preferably 0.1-3 parts by weight, and more preferably 0.2-0.7 part by weight based on 100 parts by weight of total amount of the polylactone and the aliphatic polyester resin. In the case that the addition amount exceeds 3 parts by weight, the liquid-state lubricant adheres to an internal portion of a tumbler for mixing, resulting in that it becomes difficult to stably prepare and, in the case of less than 0.1 part by weight, there can not be sufficiently shown an effect as a wetting agent.

The tendency is shown even in an outside of a range of 0.2-0.7 part by weight which is more preferred.

(3-6) Fillers

As the fillers, there are enumerated finely-powdered silica, talc, calcium carbonate, magnesium carbonate, mica, calcium silicate, white carbon, asbestos, diatomaceous earth (calcined), glass fibers, and finely-powdered particles prepared from natural materials such as papers, etc.

Purpose of employing the finely-powdered silica is to intend to prevent the blocking of a starting film or a product sheet, and during film-preparation. The finely-powdered silica may be a silica prepared by a wet method, and even a silica prepared by hydrolysis at high temperatures in an oxyhydrogen flame of silicone tetrachloride. In the finely-powdered particles, a particle diameter of not more than 50 nm is particularly preferred.

Aa a method for addition of the fillers, there is preferred a method in which those are thermally-kneaded with the polylactone alone, a resin composition composed of the polylactone and the aliphatic polyester resin, and a resin composition containing a fatty acid amide, whereby, secondarily-aggregated particles are loosened, and an effect for preventing a film blocking is shown.

Particularly, the addition amount of the finely-powdered silica most preferably ranges in 0.1-3 parts by weight based on 100 parts by weight of total amount of the polylactone and the aliphatic polyester resin in view of showing the above-described effect.

(3-7) Electro conductive agent, antistatic agent

In the case that electro static charge becomes problematic, there are employed electro conductive materials such as carbon, a powdered metal, an electro conductive resin, and nonionic, cationic or anionic antistatic agent, which are publicly-known.

(3-8) Starch

As the starch to be employed in the present invention, there are enumerated raw starch, processed starch, and a mixture thereof.

As the raw starch, there are enumerated corn starch, potato starch, sweet potato starch, wheat starch, cassava starch, sago starch, tapioca starch, rice starch, bean starch, arrowroot starch, bracken starch, lotus rhizome starch, and water chestnut starch, etc. As the processed starch, there are enumerated physically-modified starch (a-starch, classified amirose, and moisture- and thermally-treated starch); enzyme-modified starch (hydrolyzed dextrin, enzyme-modified dextrin, and amirose, etc.); chemically-modified starch (acid-treated starch, starches oxidized by hydrochloric acid, and dialdehyde starch); derivatives of the chemically-modified starch (esterified starches, etherified starch, cationized starch, and crosslinked starch, etc.), etc.

Of the above described starch, as the esterified starch, there are enumerated acetic acid-esterified starch, succinic acid-esterified starch, nitric acid-esterified starch, phosphoric acid-esterified starch, urea-phosphoric acid-esterified starch, xantgenic acid-esterified starch, and acetoacetic acid-esterified starch, etc.; as the etherified starch, there are enumerated allyletherified starch, methyl-etherified starch, carboxymethyl-etherified starch, hydroxyethyl-etherified starch, and hydroxypropyl-etherified starch, etc.; as the cationized starch, there are enumerated reaction products of starch with 2-diethylaminoethyl chloride, reaction products of starch with 2,3-epoxypropyl trimethyl ammonium chloride, etc.; as the crosslinked starch, there are enumerated starch crosslinked by formaldehyde, starch crosslinked by epichlorohydrin, starch crosslinked by phosphoric acid, and starch crosslinked by acrolein, etc.

Although the addition amount of the above-mentioned starch is not particularly limited, in order to attain a purpose of improvement in biodegradability, it is mixed in a range of 10-80 parts by weight, desirably 25-50 parts by weight based on 100 parts by weight of total amount of the polylactone and the aliphatic polyester resin.

(3-9) Coloring agent

As the coloring agent, publicly-known dyes and pigments can be employed. By the use of the coloring agent, there can be obtained a preferred resin composition having a desired color and designs, etc.

As a method for kneading the polylactone and the aliphatic polyester resin with the additives for resins to be optionally added, usual methods can be preferably employed.

Specifically, pellets, powder, and small pieces are dryblended by a Henshel mixer and a ribbon mixer, etc., and then, melt-kneaded by feeding into a single- or twin-screw extruder, a Banbury mixer, a kneader, and a mixing roll which are a publicly-known melt mixer. Further, even in the case that liquid-state additives are mixed, those can be kneaded by identical methods.

For example, an example for the preparation of the composition is illustrated below.

First of all, the polylactone, the aliphatic polyester resin, and lubricants are fed into a tumbler, followed by mixing for 10-20 minutes while agitating, and then adding an amide of a fatty acid and, further mixing for 20-30 minutes after adding a finely-powdered silica and starches. After that, melt-kneading is carried out at 140-210°C using a single- or twin-screw extruder, etc., whereby, powder or pellets of a resin composition can be obtained.

In the case that the polylactone is mixed with the aliphatic polyester resin, compatibility thereof is desired from a viewpoint of mechanical physical properties in a molded article made from the resin composition. In the case of the absence of compatibility therein, there can be preferably employed a compatibility agent for components to be mixed with the polylactone and the aliphatic polyester resin, for example, a compatibility agent such as a resin having an intermediate property between the polylactone and the aliphatic polyester resin.

In the composition of the polylactone with the aliphatic polyester resin, an appropriate melt flow index (MI) at 190°C and the load of 2160 g ranges in preferably 0.5-20 g/10 minutes, and more preferably 1-5 g/10 minutes.

(4) Method for the preparation of a biodegradable resin composition

A method for obtaining the resin composition having the above-described formulation ratio in the present invention is not particularly limited. For example, the resin composition having the above-described formulation ratio can be obtained by mixing while agitating the polylactone and the aliphatic polyester resin which are a primary resin component, and optionally a liquid state lubricant for 10-20 minute in a tumbler, and then adding an amide of a fatty acid and, further mixing for 20-30 minutes after optionally adding a finely-powdered silica and starch. After that, melt-kneading is carried out at 140-210°C using a single- or twin-screw extruder, etc., whereby, powder or pellets of the resin composition can be obtained.

2. Preparation of a biodegradable resin layer

Powder- or pellet-like composition obtained as described hereinabove is molded into a film, a sheet, non-woven fabrics, or webs, etc. by a variety of conventional molding methods, and then it can be employed for lamination with a metallic layer. For example, the film can be obtained by an inflation method or a T-die method, and the sheet can be obtained by a T-die extrusion molding method.

The thickness of the biodegradable resin layer depends upon the uses or purposes. In the film or sheet, for example, in the case of a thin layer, it is not less than 1 micron, preferably not less than 10 micron, and more preferably not less than 50 micron. In the case of a thick layer, it is not more than 10 mm, preferably not more than 1 mm, and more preferably not more than 0.5 mm.

Hereinafter, a molding method is typically illustrated by an inflation method.

First of all, it is supplied into an extruder equipped with a circular die, followed by melt-kneading at temperature of $180°C$ and by extruding in a tubular state from a slit of the circular die. For example, extruding diameter in the extruder is 40-65 mm or so, the ratio (L/D) of length/diameter is 26-32, and the diameter of the circular die is 50-100 mm, and a gap ranges in preferably 0.5-1.5 mm in the die slit.

The tubular-state film extruded is expanded until a fixed diameter in a blowing ratio (tube diameter/die diameter) of not less than 2 by pressure of a gas introduced from a gas-supplying tube which is inserted through the die, and then it is drawn in a fixed speed by rolls for nipping.

In the present invention, although a film can be stably prepared regardless of temperatures of resins extruded from the circular die or the T-die, when outside temperatures are fairly high such as in the summer season, there can be obtained a more complete film without any blocking by introducing a chilled air having not more than $20°C$ from the gas supplying tube.

3. Metallic thin layer

The metallic thin layer is composed of a metallic foil, a deposited layer, a decalcomania layer, or a plated layer, which is laminated directly or using an adhesive on the surface of the above-described biodegradable resin layer by a variety of methods.

As a method for directly laminating the metallic thin layer with the biodegradable resin layer, the following method is typically exemplified.

In lamination of a plastic film with a metallic thin layer, a dry lamination method and a hot-melt lamination method can be used.

In the case that a metal-deposited layer is formed on the surface of the plastic thin film, there can be used an ion plating method such as a vacuum deposition method, an ion plating method, and a sputtering method. It is to be noted that as a pretreating method for the ion plating method, there can be used (1) an undercoating method, (2) a top coating method, and (3) a dry top coating method.

In the case that a metallic thin layer is laminated on the surface of the plastic thin film, a decalcomania method can be used. As the decalcomania method, there can be used (1) a thermal decalcomania method, (2) a water-pressure decalcomania method, (3) a pressure-sensitive decalcomania method, and (4) a slide decalcomania method, etc.

Further, in the case that a metallic thin layer is laminated on the surface of the plastic thin film, a direct printing method and a labeling method can be used. Still further, in the case that a metallic thin layer is laminated on the surface of the plastic thin film, an electrolytic plating method and/or a nonelectrolytic plating method can be used.

As the kind of the metal, there can be enumerated aluminum, zinc, tin, copper,gold, silver, platinum, palladium, cobalt, cobalt-nickel, nickel, nickel-chrome, cobalt-chrome, SUS, and titanium, etc. Those may be employed solely or in combination of two or more kinds.

The thickness of the metallic layer depends upon the uses, and in the metallic foil, it is 0.1-100 microns, and in an ultra-thin layer such as a deposited layer, it is 70-1000 angstrom. In other methods, a layer having medium thickness can be formed.

The kind of the metal and the thickness of the metallic layer are selected according to purposes thereof.

For example, a laminated film obtained by a thermally-laminating an aluminum foil having the above-described thickness with a biodegradable resin film is effective for preventing denaturation of contents by air and heat over a long time period when powdered coffee, etc., are wrapped, and for maintaining strength and permeation resistance, etc., in a bag when thermally-cooking a retort food by boiled water.

A deposited aluminum film onto a biodegradable resin film can be employed for wrapping tobacco, etc. Thickness of the deposited layer at that time may be thinner than wave length of light. In considering a light-shielding property, moisture resistance, and a gas barrier property, the above-described thickness range is preferred and economical.

Further, for the purpose of designing on the surface of a plastic-made molded article, a thin layer of a noble metal having the thickness of 0.01-1 micron or so is printed on a decalcomania film having a cover paper, and then the film is thermally compressed onto a molded article, and then, the cover paper is stripped, whereby, a metallic thin layer can be transcribed onto the surface of the molded article.

4. Adhesive layer

In the degradable laminated body, optionally, an adhesive layer can be formed on at least portion of one surface of the biodegradable resin layer, and a metallic thin layer can be formed on the adhesive layer.

On the surface of the biodegradable resin layer on which an adhesive layer is formed, the surface can be in advance roughened by a treatment of corona discharge, whereby, the adhesive layer can be firmly stuck onto the biodegradable resin layer.

By the formation of the adhesive layer onto the biodegradable resin layer, an adhesive power can be maintained in spite of a move of a plasticizer, etc. contained in the biodegradable resin layer to an interface of the biodegradable resin layer with the adhesive layer, whereby, a decline of an adhesive power can be suppressed between the adhesive layer and the metallic thin layer.

Further, since the adhesive layer connects the biodegradable resin layer to the metallic thin layer, a stronger adhesive power can be obtained compared to a case that the metallic thin layer is directly formed on the biodegradable resin layer.

Still further, in the case that metal-deposition is carried out in the adhesive layer, an unnecessary oxidation of the metals can be decreased owing to absorbing deposited metal particles.

Also, the adhesive layer can smooth the surface of the biodegradable resin layer roughened by the pretreatment such as a corona discharge, that is, the surface of a film can be smoothed.

As an adhesive which constructs the adhesive layer, there can be enumerated a hot-melt adhesive, a phenol resin-based adhesive, a urea resin-based adhesive, a melamine resin-based adhesive, a vinyl acetate resin-based adhesive, an acrylic resin-based adhesive, a cellulose resin-based adhesive, a urethane resin-based adhesive, a latex-based adhesive, an acrylic emulsion-based adhesive, a natural rubber-based adhesive, or an epoxy resin-based adhesive, etc.

In the dry lamination, there can be preferably employed a hot-melt adhesive, a two-part curable type adhesive, or an active energy ray-curable type adhesive.

As the two-part curable type adhesive, there are enumerated a publicly known urethane resin-based adhesive or an epoxy resin-based adhesive, etc.

As the active energy ray-curable type adhesive, there are enumerated a publicly known urethane resin-based adhesive or an acrylic resin-based adhesive, etc., which can be cured by an electronic beam or an ultraviolet ray.

Use amount of the adhesives is 0.1-100 $g/m^2$, preferably 1-10 $g/m^2$ based on a cured layer.

5. Surface coating layer

In the surface of the degradable laminated body of the present invention, a surface coating layer can be optionally formed. The surface coating is formed when an excellent result can not be obtained in the case that an additional decoration such as a printing is carried out, and it is directly carried out on the metallic thin layer.

Further, the surface coating layer can prevent the metallic thin layer from sunlight, temperature, and moisture, and it can suppress a color change and denaturation.

For the surface coating layer, there can be employed the above-described biodegradable resin composition and a publicly-known undercoating. As the undercoating, there are enumerated, for example, a lacquer undercoating, a vinyl chloride-based undercoating, a vinyl acetate-based undercoating, an acrylic-based undercoating, rubber-based undercoating, alkyd-based undercoating, epoxide-based undercoating, and urethane-based undercoating.

The surface coating layer can be formed by curing after coating the above-described biodegradable resin composition or the undercoating over the metallic thin layer.

However, in the case that a special ink for molding a vinyl resin having an excellent affinity to the aluminum thin layer is employed, the surface coating is not necessary.

In the surface of the surface coating layer, there can be carried out an offset printing, an ultraviolet ray offset printing, a gravure printing, a silk-screen printing, or a flexo-printing, etc.

6. Pressure sensitive adhesive layer

In the case that the laminated body is employed for a displaying seal or tape, a pressure sensitive adhesive layer is formed in the back surface (the opposite surface to the displaying surface), and the laminated body can be stuck on other articles (for example, an automatic vending machine and a door of a room).

As a pressure sensitive adhesive to be employed for the pressure sensitive adhesive layer, there can be employed ones in which a conventional base elastomer or a base resin is mixed with a tackifier, fillers, and softeners, etc. As the base elastomer, there can be exemplified a natural resin, an SBR, a butyl rubber, and a polyisobutylene. As the base resin, there can be exemplified a polyvinyl methyl(ethyl)ether and an acrylic-based polymer. As the tackifier, there can be exemplified a rosin-based resin, a terpene-based resin, and a petroleum-based resin, etc.

The thickness of the pressure sensitive adhesive layer is 0.01-0.5 mm or so, After setting a releasing paper on the surface of the pressure sensitive adhesive layer, it is stored as a product of the laminated body having a pressure sensitive adhesive layer.

7. Construction of the laminated body

Hereinafter, there is illustrated a construction of a variety of the degradable laminated bodies of the present invention.

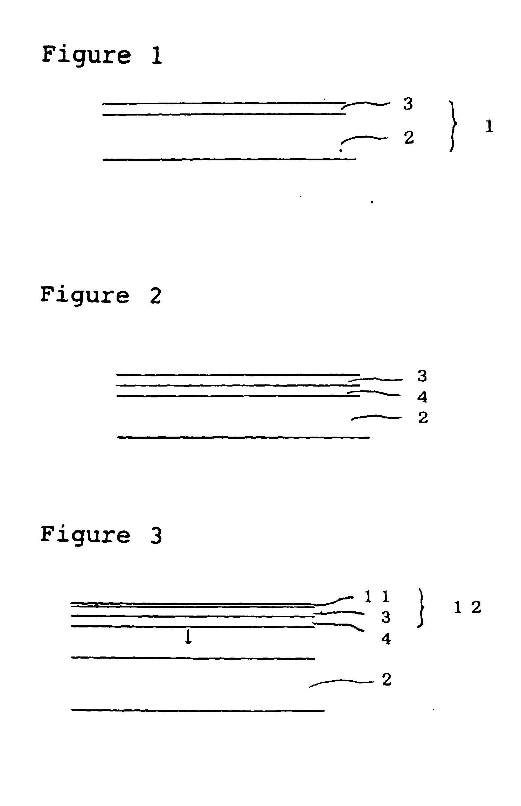

Figure 1 shows a cross-sectional drawing of a degradable laminated body 1 having one piece of a biodegradable resin layer 2 and one piece of a metallic thin layer 3, respectively.

The metallic thin layer 3 may be even formed on at least one portion of one surface in the biodegradable resin layer 2 and, contrarily, the biodegradable resin layer 2 may be also formed on at least one portion of one surface in the metallic thin layer 3.

Of course, those may be also formed on total surface of the respective layers, respectively.

As one modification of the laminated body shown in the figure 1, there are enumerated a laminated body in which one piece of the metallic thin layer is sandwiched between two pieces of the biodegradable resin layer, a laminated body in which one piece of the biodegradable resin layer is sandwiched between two pieces of the metallic thin layer, and a laminated body in which the biodegradable resin layer and the metallic thin layers form a multi-layer by turns.

Figure 2 shows a cross-sectional drawing of a degradable laminated body 1 having an adhesive layer 4 between a biodegradable resin layer 2 and a metallic thin layer 3.

As a modification thereof, there are enumerated a laminated body in which one piece of the metallic thin layer is sandwiched between two biodegradable resin layers through an adhesive layer, and a laminated body in which one piece of the biodegradable resin layer is sandwiched between two pieces of the metallic thin layer, and a laminated body in which the biodegradable resin layer and the metallic thin layers form a multi-layer by turns.

Further, in the case that the biodegradable resin layer requires the adhesive layer with the metallic thin layer or does not require, the adhesive layer may be also formed only in the case of requiring. The adhesive layer may be formed on the biodegradable resin layer or on the metallic thin layer. In the case that the thickness of the metallic thin layer 3 is thinner, the metallic thin layer 3 can be also formed on the adhesive layer 4 formed on the biodegradable resin layer.

Figure 3 shows a cross-sectional drawing of a process for obtaining a degradable laminated body composed of a laminated body for decalcomania and a film, in which a decalcomania material 12 is prepared by forming a metallic thin layer 3 on a cover paper 11 for decalcomania, and an adhesive layer 4 is formed on the metallic thin layer 3 in the decalcomania material 12, and then laminated with the biodegradable resin layer 2 through the adhesive layer 4 to the direction shown by the arrow mark.

After laminated, the cover paper 11 for decalcomania is stripped from the laminated body composed of a laminated body for decalcomania and a film to obtain a degradable laminated body 1.

Hereinafter, a method for the preparation of the degradable laminated body by a decalcomania method is illustrated using an aluminum-deposited layer as a metallic thin layer.

The cover paper 11 for decalcomania is stripped and it is separately treated. Accordingly, it does not always require biodegradability. As the specific cover paper, there are employed a polypropylene, a polyester, a polyethylene, a polyvinylchloride, and a polyamide, or the combination thereof, and a regenerated cellulose. Of course, a biaxially oriented polypropylene film in which the surface is not modified is preferably employed because of an excellent strippability and capability of reusing.

Still further, an adhesive power of the cover paper 11 for decalcomania to the aluminum-deposited layer 3 must be smaller than an adhesive power of the adhesive layer 4 to the aluminum-deposited layer 3. Whereby, the cover paper 11 for decalcomania can be readily stripped from the aluminum-deposited layer, and the the aluminum-deposited layer can be readily transcribed onto the adhesive layer 4 which is formed on the surface of the biodegradable resin layer 2.

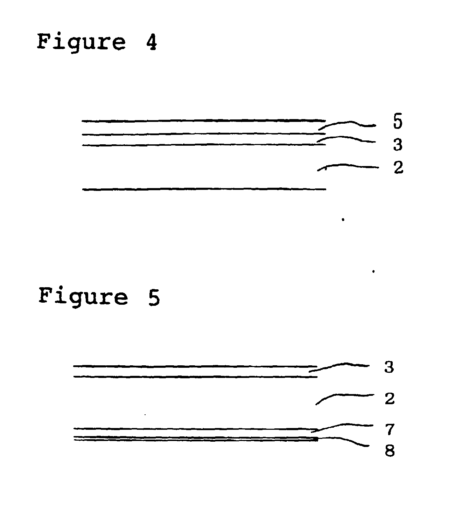

Figure 4 shows a cross-sectional drawing of the degradable laminated body 1 in which a surface coating layer 5 is formed on the surface of the metallic layer in the degradable laminated body 1 shown in the Figure 1.

As a modification thereof, the surface coating layer 5 can be also formed on the surface of the metallic layer in the degradable laminated body 1 shown in the above-described respective Figures and modification examples.

Figure 5 shows a cross-sectional drawing of the degradable laminated body 1 in which a pressure sensitive adhesive layer 7 is formed on the opposite surface to the surface which comes contact with the metallic thin layer 3 of the biodegradable resin layer 2 in the degradable laminated body 1 shown in Figure 1, and a releasing paper 8 is formed on the surface of the pressure sensitive adhesive layer 7.

As a modification thereof, the pressure sensitive adhesive layer 7 is formed on the opposite surface to the surface which comes contact with the metallic thin layer 3 of the biodegradable resin layer 2 in the degradable laminated body 1 shown in the above-described respective Figures and the modification thereof, and a releasing paper 8 can be also formed on the surface of the pressure sensitive adhesive layer 7.

8. Uses

In the degradable laminated body of the present invention, a strength is high in the biodegradable resin layer itself, degradability and biodegradability are excellent, and static electricity is not apt to be charged, and dust is not apt to be pulled because of the presence of a moisture absorbing property.

Further, since it is characterized by an excellent affinity to inks, the degradable laminated body laminated with the metallic layer has properties for decoration printing, for a gas barrier, for shielding light, and for a hard coating. And, it is employed for a wrapping film (for foods and electric parts, etc.). Further, it is employed as a label and tape, etc. by forming a pressure sensitive adhesive layer. Still further, it can be also employed as an electric conducting film, and a magnetic tape, etc., which are not apt to pull dust, and which have degradability or biodegradability.

Hereinafter, although the present invention is specifically illustrated below by Examples, the present invention is not limited by the Examples.

It is to be noted that "%" and "part" in the Examples are based on the weight so far as not described.

Melt Index: It is a value at $190°C$ and the loading of 2160 g.

Mechanical properties: Mechanical strength and extension at break are measured by using No. 3 Dumbbell according to JIS 7112.

Heat resistance: 2 layers of resin samples (30 mm x 30 mm x 1 mm) were laminated and heated in an oven to observe a melting and sticking state and, there was measured a minimum temperature at which melting and sticking are caused.

Biodegradability: Biodegradability was measured from a volume of consumed oxygen in an active sludge according to JIS K6950.

Results are shown by a degradable ratio at a period of 4 weeks after cultivation.

(Production Example 1)

A flask equipped with an agitator, a branched tube for streaming, a tube for introducing a gas, and a vacuum line was charged with 35.4 g of succinic acid (Mw: 118), 29.1 g of 1,4-butanediol (Mw: 90), and 0.02 g of tetraisopropyl titanate, followed by allowing to react at $200°C$ for 2 hours in ordinary pressures and nitrogen atmosphere while agitating. Successively, after internal pressure attained to below 0.5 mmHg while gradually reducing pressures, reactants were agitated at $200°C$ for 5 hours while removing water and an excessive amount of 1,4-butanediol from reaction system to obtain a polyester resin.

Subsequently, 0.8 g of hexamethylene diisocyanate (Mw: 168) was added at $200°C$ in a nitrogen atmosphere under ordinary pressures to increase a molecular weight of the polyester resin and to obtain a Polyester Resin (A) having urethane bonds.

The Polyester Resin (A) having urethane bonds exhibited a number average molecular weight of approximately 44,000 and a weight average molecular weight of approximately 185,000 based on a standard Polystyrene with a GPC.

The Polyester Resin (A) was kneaded with a polycaprolactone to mold sheet samples as described below.

There was mixed 100 parts by weight of the Polyester Resin A with 11.1 parts by weight of a polycaprolactone resin having a number average molecular weight of 70,000 (PCL H7 having the relative viscosity of 2.60 manufactured by Daicel Chemical Industries, Ltd.) at $150°C$ in a laboratory mixer which rotates at 30 rpm. After torque in the mixer became constant, it was further kneaded for 10 minutes while heating to obtain a polyester resin composition. The polyester resin composition obtained was molded with a press equipped with a molding die while heating to obtain a resin sheet having 150mmL x 150mmW x 1mmT. Molding was carried out at preheating temperature of $150°C$ for 10 minutes, and then by compression while heating at the conditions of $150°C$ and $100kg/cm^2$ for 10 minutes. The resin sheet molded was taken out of the molding die after naturally cooled.

(Production Example 2)

A flask equipped with an agitator, a branched tube for streaming, a tube for introducing a gas, and a vacuum line was charged with with 43.8 g of dimethyl succinate (Mw: 146), 29.1 g of 1,4-butanediol, and 0.02 g of tetraisopropyl titanate, followed by allowing to react (a transesterification reaction) at 190°C for 2 hours in ordinary pressures and nitrogen atmosphere while agitating. Successively, after internal pressure attained to 1-0.5 mmHg while gradually reducing pressures, reactants were agitated at 200°C for 8 hours while removing methanol produced in the reaction and an excessive amount of 1,4-butanediol from the reaction vessel to obtain a polyester resin. Furthermore, heating was continued at 210 to 220°C while agitating under a reduced pressure of 1-0.5 mmHg for 5 hours to remove methanol and 1,4-butanediol to obtain a Polyester Resin (B). The Polyester Resin (B) exhibited a number average molecular weight of approximately 38,000 and a weight average molecular weight of approximately 75,000 based on a standard Polystyrene with a GPC.

The Polyester Resin (B) was kneaded with a polycaprolactone to mold sheet samples as described below.

There was mixed 100 parts by weight of the Polyester Resin (B) with 11.1 parts by weight of a polycaprolactone resin having a number average molecular weight of 10,000 (PCL H1P having the relative viscosity of 1.28 manufactured by Daicel Chemical Industries, Ltd.) at 150°C in a laboratory mixer which rotates at 30 rpm. After torque in the mixer became constant, it was further mixed for 10 minutes while heating to obtain a polyester resin composition. The polyester resin composition obtained was molded with a press equipped with a molding die while heating to obtain a resin sheet having 150mmL x 150mmW x 1mmT. Molding was carried out at preheating temperature of 150°C for 10 minutes, and then by compression while heating at the conditions of 150°C and 100kg/cm$^2$ for 10 minutes. The resin sheet molded was taken out of the molding die after naturally cooled.

(Comparative Production Example 1)

There was thermally kneaded 100 parts by weight of the Polyester Resin (A) in a laboratory mixer which rotates with rotation speed of 30 rpm at 150°C for 10 minutes until torque in the mixer becomes constant, and molded with a press equipped with a molding die while heating to obtain a resin sheet having 150mmL x 150mmW x 1mmT. Molding was carried out at preheating temperature of 150°C for 10 minutes, and then by compression while heating at the conditions of 150°C and 100kg/cm$^2$ for 10 minutes. The resin sheet molded was taken out of the molding die after naturally cooled.

(Comparative Production Example 2)

There was thermally kneaded 100 parts by weight of the Polyester Resin (B) in a laboratory mixer which rotates with rotation speed of 30 rpm at 150°C for 10 minutes until torque in the mixer becomes constant, and molded with a press equipped with a molding die while heating to obtain a resin sheet having 150mmL x 150mmW x 1mmT. Molding was carried out at preheating temperature of 150°C for 10 minutes, and then by compression while heating at the conditions of 150°C and 100kg/cm$^2$ for 10 minutes. The resin sheet molded was taken out of the molding die after naturally cooled.

(Comparative Production Example 3)

There was thermally kneaded 100 parts by weight of the polycaprolactone resin having a number average molecular weight of 70,000 (PCL H7 having the relative viscosity of 2.60 manufactured by Daicel Chemical Industries, Ltd.) in a laboratory mixer which rotates with rotation speed of 30 rpm at 150°C for 10 minutes until torque in the mixer becomes constant, and molded with a press equipped with a molding die while heating to obtain a resin sheet having 150mmL x 150mmW x 1mmT. Molding was carried out at preheating temperature of 150°C for 10 minutes, and then by compression while heating at the conditions of 150°C and 100kg/cm$^2$ for 10 minutes. The resin sheet molded was taken out of the molding die after naturally cooled.

There were evaluated mechanical properties, thermal stability, and biodegradability in relation to respective resin sheets obtained in Production Examples 1, 2 and Comparative Production Examples 1, 2, and 3.

Mechanical properties were measured with Dumbbell test pieces, thermal stability was measured with test pieces having square sheets having the side of 30 mm, melting viscosity was measured with small pieces of resins, biodegradability was measured with powder made from the respective resin sheets.

[Example 1]

An aluminum foil having the thickness of 10 μm was laminated with the sheet obtained in the Production Example 1 at 180°C to obtain a degradable laminated body having an aluminum layer. The degradable laminated body was crushed and it was supplied for a biodegradability test under a municipal drainage circumstance for 28 days according to the JIS K6950.

[Example 2 and Comparative Examples 1-3]

An aluminum foil having the thickness of 10 μm was likewise laminated with the sheets obtained in the Production Example 2 and Comparative Examples 1-3 as in Example 1 to obtain degradable laminated bodies.

There were evaluated mechanical properties, thermal stability, and biodegradability in relation to respective resin sheets obtained in Production Example 2 and Comparative Production Examples 1, 2, and 3.

Mechanical properties were measured with Dumbbell test pieces, thermal stability was measured using test pieces of square sheets having the side of 30 mm, melting viscosity was measured using small pieces of resins, biodegradability was measured using powder made from the respective resin sheets.

Results are shown in Table 1.

Table 1

| | Production Example 1 | Production Example 2 | Production Comparative Example 1 | Procution Comparative Example 2 | Production Comparative Example 3 |
|---|---|---|---|---|---|
| Strength at break (kg/cm$^2$) | 620 | 340 | 600 | 355 | 610 |
| Extension at break (%) | 560 | 285 | 530 | 280 | 730 |
| Heat resistance (°C) | 115 | 115 | 118 | 118 | 60 |
| | Example 1 | Example 2 | Comparative Example 1 | Comparative Example 2 | Comparative Example 3 |
| Biodegradability (%) | 36 | 40 | 2 | 15 | 81 |

It is shown by the Table 1 that actual results of biodegradability tests in the Examples 1 and 2 are improved in approximately 260% and 100%, respectively, compared to biodegradability to be expected from a mixing ratio of the polycaprolactone with the Polyester resins (A) and (B).

From the results, it can be understood that the polycaprolactone induces the degradation of the Polyester resins (A) and (B).

As described above, it is clearly shown that biodegradability is improved by mixing with the polycaprolactone without a decline of physical properties such as a melting point of an aliphatic polyester resin.

<Preparation of a resin composition>

[Preparation 1]

40 parts by weight of a polycaprolactone, 60 parts by weight of a poly-1,4-butanediol-succinate, and 0.5 part by weight of liquid paraffin, 1 part by weight of an amide of stearic acid were fed into a twin-screw and ventilation type extruder, followed by extruding at a die temperature of 180°C to obtain pellets of a resin composition. Melt Index was 3.5 g/10 minutes in the resin composition.

[Preparation 2]

40 parts by weight of a polycaprolactone, 60 parts by weight of a poly-1,4-butanediol-succinate, and 0.5 part by weight of a liquid paraffin, 0.8 part by weight of an amide of stearic acid, and 0.8 part by weight of Aerojil #200 (manufactured by Nihon Aerojil, Co.) were fed into a twin-screw and ventilation type extruder, followed by extruding at a die temperature of 180°C to obtain pellets of a resin composition. Melt Index was 3.9 g/10 minutes in the resin composition.

[Preparation 3]

40 parts by weight of a polycaprolactone, 60 parts by weight of a poly-1,4-butanediol-succinate, and 0.5 part by weight of a liquid paraffin, 0.5 part by weight of an amide of stearic acid, and 0.5 part by weight of Aerojil #200 (manufactured by Nihon Aerojil, Co.) were fed into a twin-screw and ventilation type extruder, followed by extruding at a die temperature of 180°C to obtain pellets of a resin composition. Melt Index was 3.7 g/10 minutes in the resin composition.

[Preparation 4]

40 parts by weight of a polycaprolactone, 60 parts by weight of a poly-1,4-butanediol-succinate, and 0.5 part by weight of a liquid paraffin, 0.5 part by weight of an amide of stearic acid, 0.5 part by weight of Aerojil #200 (manufactured by Nihon Aerojil, Co.), and 50 parts by weight of a corn starch were fed into a twin-screw and ventilation type extruder, followed by extruding at a die temperature of 180°C to obtain pellets of a resin composition. Melt Index was 2.5 g/10 minutes in the resin composition.

[Film-preparation Example 1]

A film was prepared using the resin composition prepared in the Preparation Example 1 according to the following molding conditions by an inflation method.
Extruder: an extruder having a diameter of 40 mm
Screw: L/D=28, a screw for an MDPE (a polyethylene having a medium density)
Die: lip diameter of 150 mm and die gap of 1 mm
Extrusion temperature: 170°C at an end portion of a cylinder
Die temperature: 170°C
Resin temperature (T1): 160°C
Screw rotation speed: 15 rpm
Extrusion volume: 15 kg/hr
Blowing ratio: 2.5
Blocking resistance, outer appearance, and biodegradability were measured in relation to the inflation film obtained according to the following methods.
Blocking property: A tube (total length of 100 m) was drawn by folding through rolls for nipping in a drawing machine, and it was checked whether it can be readily pulled apart or not by fingers.
Film which can be readily pulled apart was judged as the absence of blocking.
Outer appearance of the film: There were checked the presence or the absence of mingling of unmelted gels, streaks, and foaming, etc., and smoothness of the surface. Films having an excellent smoothness of the surface, in which mingling of unmelted gels, streaks, and foaming, etc., are not observed, were judged as the excellence.
Results are shown in Table 2.

[Film-preparation Examples 2-4]

A film was likewise prepared according to the same conditions using the resin composition prepared in the Preparation Examples 2-4 to likewise evaluate as in Film-preparation Example 1.
Evaluation results are shown in Table 2.

[Example 3]

The film prepared in the Preparation Example 1 was corona-discharged, and aluminum was deposited on one surface of the film in the thickness of approximately 200 angstrom to obtain a degradable laminated body having an aluminum-deposited layer.
Evaluation results in relation to the degradable laminated body are shown in Table 2.
A design was printed on the aluminum-deposited surface in the degradable laminated body, and a natural rubber-based pressure sensitive adhesive layer was formed on the surface of the resin composition layer to obtain a rolled film for a label.

[Examples 4-6]

Films obtained in the Film-preparation Examples 2-4 were likewise handled as in the Example 3 to obtain degradable laminated bodies having an aluminum-deposited layer.
Table 2 shows evaluation results in relation to the degradable laminated bodies.
A design was printed on the aluminum-deposited surface in the degradable laminated body, and a natural rubber-based pressure sensitive adhesive layer was formed on the surface of the resin composition layer to obtain a rolled film for a label.

Evaluation results in the Examples 3-6 are shown in Table 2.

Table 2

| FPE | APFB | OAF | E | B |
|---|---|---|---|---|
| FPE 1 | none | excellence | Example 3 | 75% |
| FPE 2 | none | excellence | Example 4 | 73% |
| FPE 3 | none | excellence | Example 5 | 75% |
| FPE 4 | none | excellence | Example 6 | 85% |

In the Table 2, abbreviations are as follows

FPE: Film-preparation Example

APFB: Absence or Presence of film blocking

OAF: Outer Appearance of Films

E: Examples

B: Biodegradability

[Example 7]

An adhesive (an acrylic emulsion-based adhesive) was coated on the aluminum layer of the degradable laminated body having an aluminum-deposited layer obtained in the Example 3, and was laminated with the film obtained in the Film-preparation Example 1 as a surface coating layer to obtain a laminated body.

The laminated body obtained was placed in a compost for 2 weeks, as a result, the film was decomposed.

According to the present invention, there can be obtained a degradable laminated body having a metallic thin layer, which can be readily decomposed by biodegradation or degradation in a short period of time under a natural circumstance.

While the invention has been described in detail and with reference to specific embodiments thereof, it will be apparent to one skilled in the art that various changes and modifications can be made therein without departing from the spirit and scope thereof.

**Claims**

1. A degradable laminated body which comprises (A) a biodegradable resin layer consisting essentially of a biodegradable polyester resin composition containing 100 parts by weight of an aliphatic polyester resin and 1-200 parts by weight of a polylactone resin, and (B) a metallic thin layer which is laminated with at least one surface of said biodegradable resin layer.

2. A degradable laminated body as claimed in claim 1, wherein said aliphatic polyester resin is composed of an aliphatic dicarboxylic acid and an aliphatic diol.

3. A degradable laminated body as claimed in claim 2, wherein said aliphatic dicarboxylic acid is succinic acid and/or adipic acid.

4. A degradable laminated body as claimed in claim 2, wherein said aliphatic diol is ethyleneglycol and/or 1,4-butanediol.

5. A degradable laminated body as claimed in claim 2, wherein said aliphatic polyester resin is highly-polymerized by an aliphatic polyisocyanate compound.

6. A degradable laminated body as claimed in claim 4, wherein said aliphatic polyester resin is a resin in which a polyester resin composed of succinic acid and 1,4-butanediol is highly-polymerized by hexamethylene diisocyanate.

7. A degradable laminated body as claimed in anyone of claims 1 to 6, wherein said biodegradable resin layer is an inflation film or a T-die-made film of the biodegradable polyester resin composition.

8. A degradable laminated body as claimed in anyone of claims 1 to 7, wherein said metallic thin layer is at least one kind selected from the group consisting of aluminum, zinc, tin, copper, gold, silver, platinum, palladium, cobalt, cobalt-nickel, nickel, nickel-chrome, chrome, and cobalt-chrome.

9. A degradable laminated body as claimed in anyone of claims 1 to 8, wherein said metallic thin layer is a metallic foil, a vapor-vaporized layer, a decalcomania thin layer, or a plated layer.

10. A degradable laminated body as claimed in anyone of claims 1 to 9, wherein a surface coating layer is formed on the surface of said laminated body.

11. A degradable laminated body as claimed in claim 10, wherein a pressure sensitive adhesive layer is formed on an opposite surface to the surface of said biodegradable resin layer which takes in contact with said metallic thin layer, and a releasing paper is attached to the surface of the pressure sensitive adhesive layer.

12. A degradable laminated body as claimed in anyone of claims 1 to 11, wherein said lactone resin is a polycaprolactone resin.

13. A method for the preparation of a degradable laminated body as claimed in any one of claims 1-12 by laminating a biodegradable resin layer with a metallic foil.

14. A method for the preparation of a degradable laminated body as claimed in any one of claims 1-12 by vapor-depositing a metal over the surface of said biodegradable resin layer.

15. A method for the preparation of a degradable laminated body as claimed in any one of claims 1-12 by plating a metal over the surface of said biodegradable resin layer.

16. A method for the preparation of a degradable laminated body as claimed in any one of claims 1-12 by decalcomania of a metal onto the surface of said biodegradable resin layer.

# Figure 1

# Figure 2

# Figure 3

## Figure 4

5
3
2

## Figure 5

3
2
7
8